# EUROPEAN PATENT APPLICATION

(11) **EP 4 836 603 A1**
(43) Date of publication of application: **04.11.2026**
(21) Application number: 26168214.0
(22) Date of filing: 26.03.2026
(51) Int. Cl.: H05K 5/00, H05K 7/14

(54) **POWER SUPPLY MODULE FOR A MODULAR DATA CENTRE**

(71) Applicant: Sweet Project Holdings Limited, London, Greater London EC4M 7AU (GB)
(72) Inventor: WAUGH, Andrew, Greater London, EC4M 7AU (GB); BATEMAN, Peter, Greater London, EC4M 7AU (GB); EGLEN, Matthew, Greater London, EC4M 7AU (GB)
(74) Representative: Reddie & Grose LLP

(57) **Abstract**

A power supply module (300) for a modular data centre (100) includes a first container (302) having a base and sidewalls enclosing a first volume, and a generator unit (320) located within the first volume. The power supply module (300) further includes a second container (304) having a base and sidewalls enclosing a second volume, configured to be stacked above the first container (302) with the base of the second container (304) supported by the first container (302). One or more electrical units are located within the second volume, configured to receive power from an external power supply or from the generator unit (320) and output power to a data hall (102) of the modular data centre (100). A method of constructing a power supply module and a kit of parts are also provided.

## Description

### FIELD OF INVENTION

The present disclosure relates to power supply infrastructure for data centres, and more particularly to a power supply module for a modular data centre, a modular data centre, a method of constructing a power supply module for a modular data centre, and a kit of parts for a power supply module of a modular data centre.

### BACKGROUND

Data centres provide the computational infrastructure required to support modern digital services, including cloud computing, enterprise applications, and data storage. These facilities house large numbers of computer systems, networking equipment, and associated infrastructure within purpose-built buildings designed to provide appropriate power supply, cooling, and physical security. The power requirements of data centres are substantial, with facilities ranging from relatively modest installations requiring a few megawatts of electrical power to large-scale deployments requiring tens or hundreds of megawatts. Providing reliable electrical power to data centre facilities involves multiple systems including utility grid connections, backup generators, uninterruptible power supply systems and the like.

Conventional approaches to providing power infrastructure for data centres typically involve constructing dedicated buildings or rooms to house generators, electrical switchgear, transformers, and battery systems. These power infrastructure components are often installed as separate items of equipment within a purpose-built structure, with electrical connections made on-site between the various components. The generators, which provide backup power during utility grid outages, are typically housed in separate enclosures or buildings from the electrical distribution equipment, with exhaust systems, fuel storage, and ventilation systems designed and installed specifically for each project.

The design and construction of power infrastructure for data centres using conventional approaches can be time-consuming and expensive. Each data centre project typically requires bespoke engineering work to design the power systems, specify the equipment, and plan the installation. The on-site construction work involves multiple trades including civil works for foundations and buildings, mechanical installation for generators and ventilation systems, and electrical installation for switchgear, cabling, and control systems. Coordinating these different work packages on a construction site can lead to delays, and the sequential nature of much of the work means that overall construction timelines can be lengthy. Furthermore, the bespoke nature of each installation means that economies of scale in manufacturing are difficult to achieve.

The physical footprint of power infrastructure can also present challenges for data centre operators. Generators, fuel storage tanks, electrical switchgear, transformers, and battery systems each require floor space, and when these components are arranged in conventional configurations, the total land area required for power infrastructure can be substantial. In locations where land is expensive or constrained, the footprint of power infrastructure can represent a significant cost or limitation on the overall data centre capacity that can be achieved on a given site.

Modular approaches to data centre construction have been developed to address some of the challenges associated with conventional construction methods. These approaches may involve prefabricating certain components or systems off-site and transporting them to the data centre location for installation. However, integrating power generation equipment, electrical distribution systems, and associated infrastructure into a compact, transportable, and rapidly deployable configuration while maintaining appropriate safety provisions presents technical challenges.

It has been appreciated that a power supply module is needed that overcomes one or more of these problems.

### SUMMARY

The invention is defined in the independent claims. Embodiments of the invention are set out in the dependent claims.

According to a first aspect, a power supply module for a modular data centre is provided. The power supply module comprises: a first container including a base and sidewalls, wherein the first container encloses a first volume; a generator unit located within the first volume; a second container including a base and sidewalls, wherein the second container encloses a second volume, and wherein the second container is configured to be stacked above the first container with the base of the second container supported by the first container; and one or more electrical units located within the second volume, said one or more electrical units configured to receive power from an external power supply or from the generator unit and configured to output power to a data hall of the modular data centre.

This stacked container arrangement addresses the footprint and deployment challenges identified in conventional power infrastructure designs. By positioning the second container containing electrical units above the first container containing the generator unit, the power supply module achieves a compact vertical configuration that reduces the ground-level footprint compared to side-by-side or multi-building arrangements. The stacking arrangement also removes the need for a dedicated external steel gantry that would otherwise be required to route cabling between a generator building and separate electrical building in conventional configurations.

Further, the containerised construction enables the power supply module to be manufactured off-site in a controlled factory environment and delivered to site as a pre-assembled and pre-tested unit, reducing on-site construction time and enabling rapid deployment. The structural separation between the generator unit in the first container and the electrical units in the second container provides operational flexibility and facilitates maintenance without disrupting the other systems.

In some embodiments, the one or more electrical units are configured to receive power from the generator unit during a failure of the external power supply. This configuration provides backup power capability, ensuring continuity of electrical supply to the data hall when the primary external power supply becomes unavailable. The generator unit can be activated automatically or manually in response to detection of an external power supply failure, with the electrical units managing the transition between power sources.

In some embodiments, the external power supply is a utility power supply or a grid power supply. The utility power supply or grid power supply provides the primary source of electrical power during normal operation, with the generator unit serving as a backup power source when the utility or grid supply is unavailable or fails.

In some embodiments, the base of the first container and the base of the second container have the same footprint. This configuration provides a uniform vertical profile for the power supply module, with the second container aligning directly above the first container without overhang or offset. The matching footprints facilitate structural support between the containers and enable efficient use of the available ground area.

In some embodiments, the power supply module further comprises a fire separation layer comprising a fire-retardant material, said fire separation layer disposed between the first container and the base of the second container when stacked. The fire separation layer provides fire protection between the generator unit housed in the first container and the electrical units housed in the second container, reducing the risk of fire propagation between the two containers. This fire separation is particularly important given the presence of fuel and combustion processes associated with the generator unit in the first container and the electrical equipment and batteries in the second container.

In some embodiments, the fire separation layer is removable in a direction perpendicular to the stacking direction of the first and second containers. This removable configuration facilitates maintenance, inspection, and replacement of the fire separation layer without requiring disassembly of the stacked container arrangement. The perpendicular removal direction enables the fire separation layer to be slid out from between the containers while the second container remains in position above the first container.

In some embodiments, the power supply module further comprises an exhaust unit disposed on a roof of the second container, said exhaust unit coupled to an exhaust outlet of the generator unit. This configuration routes the generator exhaust gases upward around the power supply module to a discharge point at the elevated position on the roof of the second container. The elevated discharge position promotes dispersion of exhaust gases away from ground level and away from air intakes of the power supply module, data centre, cooling system inlets, and surrounding buildings.

In some embodiments, the exhaust unit is coupled to the exhaust outlet of the generator unit via a duct that extends from the first container and around the outside of the second container. This external routing of the exhaust duct avoids the need to pass exhaust gases through the interior of the second container, thereby maintaining separation between the hot exhaust gases and the electrical equipment housed within the second container. The external duct routing also simplifies the internal layout of the second container and facilitates inspection and maintenance of the exhaust system.

In some embodiments, the exhaust unit comprises a selective catalytic reduction (SCR) system. The SCR system treats the exhaust gases from the generator unit to reduce emissions of nitrogen oxides and other pollutants before discharge to atmosphere. This emissions treatment capability enables the power supply module to comply with environmental regulations and air quality requirements that may apply at the data centre installation site.

In some embodiments, the one or more electrical units comprise: a transformer, a ring main unit (RMU), one or more switchboards, one or more uninterruptible power supply (UPS) systems, one or more batteries, or any combination thereof. The transformer converts the voltage level of the electrical power received from the external power supply to a lower voltage prior to distribution of the received electrical power to the other electrical units in the second container and on to the data centre equipment. The ring main unit distributes electrical power received from the external power supply to the transformer. The switchboards distribute the electrical power from the incoming power sources (i.e. from the external power supply via the transformer, or from the generator unit) to downstream equipment within the data centre. The uninterruptible power supply systems provide power to maintain continuity of supply during transitions between the external power supply and the generator unit. The batteries provide energy storage to support the uninterruptible power supply systems during the period between loss of external power and the generator unit reaching full operational capacity.

In some embodiments, the second container comprises one or more internal walls to partition the second volume into a plurality of compartments. The internal walls enable functional separation between different types of electrical equipment within the second container, allowing equipment with different environmental requirements, safety considerations, or maintenance access needs to be housed in dedicated compartments.

In some embodiments, the one or more internal walls comprise an internal fire separation layer comprising a fire-retardant material. The internal fire separation provides fire protection between compartments within the second container, reducing the risk of fire propagation between different sections of the electrical equipment. This is particularly important for separating battery compartments from other electrical equipment due to the fire risks associated with battery systems.

In some embodiments, the plurality of compartments includes a first compartment and a second compartment, wherein the first compartment contains one or more batteries and the second compartment contains an uninterruptible power supply system and/or a switchboard. This arrangement separates the battery storage from the power conditioning and distribution equipment, providing fire separation between the batteries and other electrical systems while maintaining the electrical connections required for the uninterruptible power supply systems to draw upon the battery energy storage.

In some embodiments, the plurality of compartments further includes a third compartment, wherein the third compartment contains a transformer. Housing the transformer in a dedicated compartment provides separation from the other electrical equipment, accommodating the different ventilation and cooling requirements of transformers and providing appropriate clearances for high voltage equipment.

In some embodiments, the second container comprises a plurality of container sections that couple together to form the second container. This modular construction of the second container enables the individual container sections to be manufactured and transported separately, with at the container sections then coupled together at the data centre installation site.

In some embodiments, the one or more internal walls are formed by the couplings between the plurality of container sections of the second container. This configuration integrates the structural connections between container sections with the internal partitioning of the second volume within the second container, providing both structural integrity and functional separation without requiring additional internal wall construction.

In some embodiments, the generator unit provides a power between 1.5MW and 10MW, preferably between 2MW and 5MW, more preferably wherein the generator unit is a 2.4MW generator. This power range is suitable for providing backup power to a portion of a modular data centre, with the specific generator capacity selected to match the power requirements of the associated data hall section.

In some embodiments, the one or more electrical units are configured to output a first power supply stream for information technology equipment of the modular data centre. The first power supply stream provides the electrical power required by the servers, storage systems, networking equipment, and other information technology (IT) equipment housed within the data hall of the data centre.

In some embodiments, the first power supply stream is output via one or more first switchboards. The one or more first switchboards may be coupled to one or more first UPS systems. The first switchboard distributes the electrical power from the incoming power sources (i.e. from the external power supply via the transformer, or from the generator unit) downstream to the IT equipment within the data centre, whilst the first UPS system prevents any power loss during transitions between the external power supply and the generator unit.

In some embodiments, the one or more electrical units are configured to output a second power supply stream for plant equipment of the modular data centre. The second power supply stream provides electrical power for the plant equipment. Such plant equipment includes equipment requiring power within the data centre other than the IT equipment. For example, such plant equipment may include heating/cooling systems, ventilation systems lighting, security systems, and other mechanical plant equipment that supports the operation of the data centre.

In some embodiments, the second power supply stream is output via one or more second switchboards. The one or more second switchboards may be coupled to one or more second UPS systems. The second switchboard distributes the electrical power from the incoming power sources (i.e. from the external power supply via the transformer, or from the generator unit) downstream to the plant equipment within the data centre, whilst the second UPS system prevents any power loss during transitions between the external power supply and the generator unit. Providing separate switchboards and UPS systems for the plant equipment enables independent management of the plant equipment from the IT equipment, whilst also making maintenance simpler and allowing different levels of power protection to be applied to plant equipment compared to IT equipment.

In some embodiments, the first power supply stream is output via a plurality of output terminals. The plurality of output terminals enables the power supply module to serve multiple downstream distribution points within the data hall, e.g. different IT equipment racks, as well as providing redundancy output terminals.

In some embodiments, each of the plurality of output terminals is associated with a respective portion of IT equipment of the modular data centre. This association enables the power supply module to provide dedicated power feeds to different sections or racks of IT equipment.

In some embodiments, the first power supply stream is equal to 1.5MW. This power level is suitable for serving a standard portion of the modular data centre, with the power supply module capacity matched to the IT load of the associated data hall section.

In some embodiments, the one or more electrical units further comprise one or more load bank connection terminals. The load bank connection terminals enable connection of resistive load banks for testing the generator unit and electrical distribution systems, allowing verification of system performance and capacity without requiring the IT equipment to be operational.

In some embodiments, the first container comprises a first compartment, a second compartment and a third compartment, wherein the first compartment comprises an air intake system configured to draw air into the first container for cooling the generator unit, the second compartment contains the generator unit, and the third compartment comprises an air discharge system configured to expel from the first container air heated by the generator unit. This three-compartment arrangement provides an airflow path through the first container to cool the generator unit when in operation.

In some embodiments, the air intake system comprises an inlet ventilation attenuator and/or the air discharge system comprises a discharge ventilation attenuator. The ventilation attenuators reduce noise emissions from the generator unit by attenuating the sound transmitted through the air intake and discharge openings, reducing noise during operation at the installation site.

In some embodiments, the first compartment is located at a first end of the first container, the third compartment is located at a second end of the first container opposing the first end, and the second compartment is located between the first compartment and the third compartment. This linear arrangement optimises the airflow path through the first container and positions the air intake and discharge openings at opposite ends of the container to minimise recirculation of heated air.

In some embodiments, the first compartment includes a first acoustic louvre passing through a sidewall of the first container, preferably passing through a first end wall of the first container, and the third compartment includes a second acoustic louvre passing through a sidewall of the first container, preferably passing through a second end wall of the first container. The acoustic louvres provide weather protection for the air intake and discharge openings while contributing to noise reduction.

In some embodiments, the power supply module further comprises a fuel module configured to receive the first container with the base of the first container supported by the fuel module. The fuel module provides a space beneath the first container for accommodating fuel storage, cable routing, or the like.

In some embodiments, the base of the first container comprises a fuel module integral with the first container. This integrated construction combines the fuel module with the container base, reducing the number of separate components and simplifying installation.

In some embodiments, the power supply module further comprises a fuel tank positioned within the fuel module and configured to provide fuel to the generator unit. Positioning the fuel tank within the fuel module utilises the space beneath the first container for fuel storage, maintaining the compact footprint of the power supply module while providing adequate fuel capacity for extended generator operation.

In some embodiments, the power supply module further comprises a fuel tank located within the first volume and configured to provide fuel to the generator unit. This alternative fuel tank arrangement houses the fuel storage within the first container, enabling easier access to the fuel tank.

In some embodiments, the first container comprises a plurality of container sections that couple together to form the first container. This modular construction of the first container enables the individual container sections to be manufactured and transported separately, facilitating delivery to sites enabling final assembly at the installation location.

In some embodiments, the power supply module is a modular assembly, wherein the first container forms a first storey of the modular assembly and the second container forms a second storey of the modular assembly.

In some embodiments, the power supply module further comprises a ladder or staircase that extends along an outside wall of the first container for accessing the second container. The external access arrangement provides personnel access to the second container for operation and maintenance of the electrical equipment without requiring internal access through the first container.

According to a second aspect, a modular data centre is provided comprising at least one data hall and one or more power supply modules according to the first aspect configured to provide power to the data hall.

According to a third aspect, a method of constructing a power supply module for a modular data centre is provided. The method comprises the steps of: providing a first container including a base and sidewalls, wherein the first container encloses a first volume containing a generator unit; providing a second container including a base and sidewalls, wherein the second container encloses a second volume containing one or more electrical units, said one or more electrical units configured to receive power from an external power supply or from the generator unit and configured to output power to a data hall of the modular data centre; and stacking the second container above the first container with the base of the second container supported by the first container.

In some embodiments, the method further comprises coupling the second container to the first container during or after the stacking. The coupling secures the second container to the first container, providing structural integrity for the stacked arrangement.

In some embodiments, providing the second container further comprises the steps of providing a plurality of second container sections and coupling the plurality of second container sections together to form the second container. This sectional assembly enables the second container to be constructed from smaller transportable units.

In some embodiments, providing the first container further comprises the steps of providing a plurality of first container sections and coupling the plurality of first container sections together to form the first container. This sectional assembly enables the first container to be constructed from smaller transportable units.

According to a fourth aspect, a kit of parts for a power supply module of a modular data centre is provided. The kit of parts comprises: a first container including a base and sidewalls, wherein the first container encloses a first volume; a generator unit; a second container including a base and sidewalls, wherein the second container encloses a second volume, and wherein the second container is configured to be stacked above the first container with the base of the second container supported by the first container; and one or more electrical units, said one or more electrical units configured to receive power from an external power supply or from the generator unit and configured to output power to a data hall of the modular data centre.

In some embodiments, the kit of parts further comprises an exhaust unit configured to be disposed on a roof of the second container and coupled to an exhaust outlet of the generator unit.

### BRIEF DESCRIPTION OF FIGURES

Embodiments of the invention will be described, by way of example, with reference to the following drawings, in which:
FIG. 1 illustrates an isometric view of a modular data centre.
FIG. 2 illustrates an isometric view of a power supply module arrangement adjacent to a data hall.
FIG. 3 illustrates an isometric view of a power supply module comprising a stacked container arrangement.
FIG. 4 illustrates an isometric view of the power supply module of FIG. 3 from a different angle.
FIG. 5 illustrates a floor plan view of a first container of the power supply module of FIG. 3.
FIG. 6 illustrates a floor plan view of a second container of the power supply module of FIG. 3.
FIG. 7 illustrates a detailed view of a coupling region between the first container and the second container of the power supply module of FIG. 3.
FIG. 8 illustrates an exploded isometric view of components of a power supply module.
FIG. 9 illustrates a perspective view of a first container for housing a generator unit.
FIG. 10 illustrates a detailed perspective view of a docking element of the first container of FIG. 9.
FIG. 11 illustrates a detailed cross-sectional view of a docking arrangement between a first container and a second container.
FIG. 12 illustrates a detailed cross-sectional view of a stacked container arrangement with a fire separation layer.
FIG. 13 illustrates a flowchart of a method for constructing a power supply module for a modular data centre.

Common reference numerals are used throughout the figures to indicate similar features.

### DETAILED DESCRIPTION

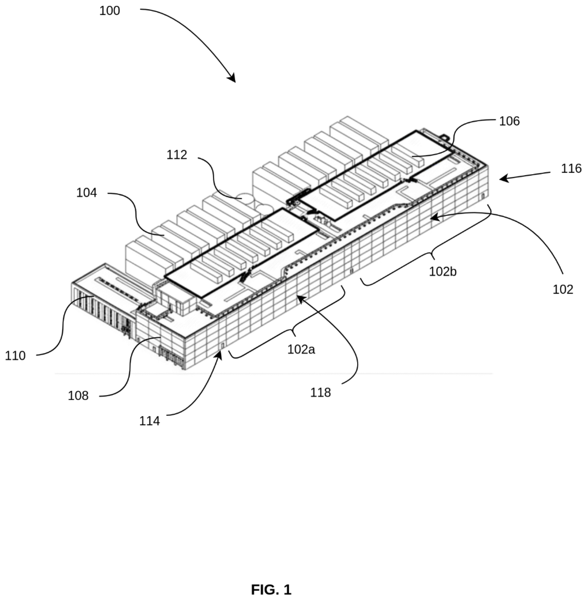

FIG. 1 illustrates an isometric view of a modular data centre 100. The modular data centre 100 comprises a data hall 102 configured to house a plurality of computer systems. The data hall 102 is divided into a first sub-hall 102a and a second sub-hall 102b. The first sub-hall 102a and the second sub-hall 102b may be configured to operate independently, enabling the data hall 102 to serve two different operating clients independently when the data hall 102 is split down the middle.

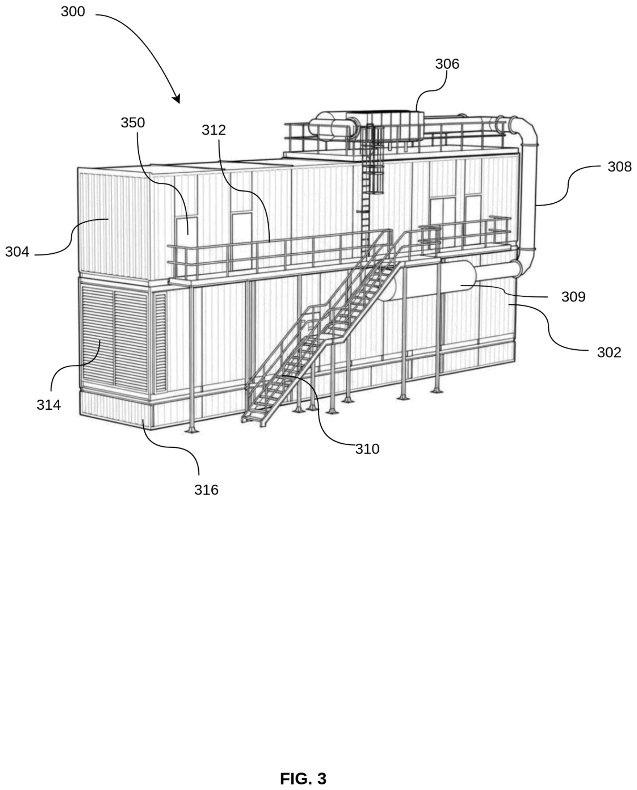

A plurality of power supply modules 104 are arranged linearly adjacent to the data hall 102. Each power supply module 104 is structurally separate from the data hall 102, with a gap between each power supply module 104 and the data hall 102. The power supply modules 104 are configured to provide electrical power to the data hall 102, and will be described in more detail in relation to FIG. 3 onwards.

A plurality of modular cooling units 106 are positioned on the roof of the data hall 102. The modular cooling units 106 are arranged in rows along the length of the data hall 102 and are configured to provide cooling to the data hall 102.

Sprinkler water tanks 112 are located near the power supply modules 104. Water tanks 112 are configured to supply water for sprinkler operations of the modular data centre 100. Such water tanks may be located anywhere within the data centre in general.

A logistics building 108 is attached at one end of the data hall 102. The logistics building 108 shares the same width as the data hall 102. The logistics building 108 may house goods lifts, stores, delivery entrances, and other functional sections required for operation of modular data centre 100. An administrative building 110 is positioned adjacent to the logistics building 108. The administrative building 110 is configured to house personnel and administrative functions associated with the modular data centre 100. For example, the administrative building 110 may take the form of an office building.

The data hall 102 includes a first end portion 114 at one end, a second end portion 116 at the opposite end, and one or more middle portions 118 arranged in a repeating linear fashion between the first end portion 114 and the second end portion 116. Each of the first end portion 114, the second end portion 116, and the middle portions 118 has a respective power supply module 104 associated with the respective portion. The respective power supply module 104 is configured to provide a power required by the associated portion when the modular data centre 100 is in operation. As illustrated, each of the first end portion 114, the second end portion 116, and the middle portions 118 has two power supply modules 104 associated with it, though in some cases more or fewer power supply modules 104 may be associated with each portion. In some cases, each portion may be able to have a different number of power supply modules 104 associated with it.

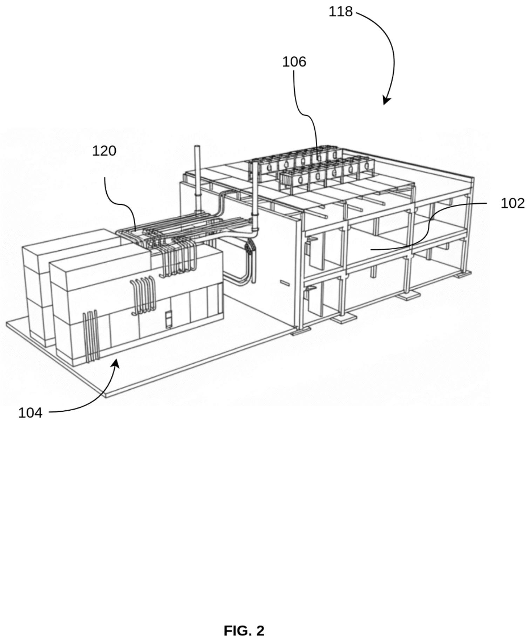

FIG. 2 illustrates an isometric view of a power supply module 104 arrangement adjacent to a middle portion 118 of the data hall 102. The figure illustrates two power supply modules 104 adjacent to the middle portion 118. In some configurations, each portion may have two power supply modules 104 associated with it, where one power supply module 104 provides the primary power supply for the portion and the other power supply module 104 may provide a redundancy power supply. In other configurations, each portion may have a single power supply module 104 associated with it, with one or more additional redundancy power supply modules 104 shared between multiple portions. The exemplary power supply module 104 comprises a stacked container arrangement configured to provide electrical power to the associated middle portion 118 of the data hall 102, as will be discussed in more detail in FIG. 3 onwards. In particular, cable routing infrastructure 120 connects the power supply module 104 to the data hall 102. The cable routing infrastructure 120 carries electrical power cables and control cables between the power supply module 104 and the electrical distribution equipment within the data hall. The electrical power from the power supply module 104 is used to power IT equipment contained within the data hall, and plant equipment in the data hall such as the modular cooling units 106. Such plant equipment may also be referred to as building services equipment herein, and relates to any equipment other than the IT equipment, such as heating/cooling systems, ventilation systems lighting, security systems, and other mechanical plant equipment that supports the operation of the data centre.

The power supply module 104 is designed as a modular, standardised unit that can be manufactured in volume and deployed across multiple data centre installations. This can significantly increase the speed of constructing data centres compared to conventional bespoke power infrastructure installations, as well as enabling scalability for data centre operators. Each power supply module 104 may have identical specifications and configurations, enabling mass production efficiencies that reduce per-unit manufacturing costs compared to bespoke power supply installations designed individually for each data centre project. The standardisation of power supply modules 104 also simplifies procurement, as identical units can be ordered in varying quantities depending on the required data centre capacity, and enables the establishment of supply chain relationships with manufacturers who can produce these units at scale.

The middle portion 118 and power supply module 104 arrangement illustrated in FIG. 2 may be replicated multiple times to extend the data hall 102. Because each portion (first end portion 114, second end portion 116, and middle portions 118) has its own associated power supply module 104, the power capacity of the modular data centre 100 scales proportionally with the size of the data hall 102. When additional middle portions 118 are added to extend the data hall 102, each additional middle portion 118 brings its own power supply module 104, ensuring that power capacity automatically scales with the data hall 102 size. This eliminates the need for complex recalculations of power infrastructure when adjusting data centre capacity, as the power requirements are predetermined and factored into the design of each portion.

FIG. 3 illustrates an isometric view of a power supply module 300, which may be used as the power supply module 104 of FIG. 2. In general, the power supply modules 104 and 300 may be referred to as combined generator and electrical modules or containerized generator and electrical modules. The power supply module 300 has a stacked container arrangement. The power supply module 300 includes a first container 302 positioned at a lower level forming the base of the stacked arrangement, and a second container 304 positioned above the first container 302. The first container 302 may also be referred to as a generator enclosure herein, and the second container 304 may also be referred to as an electrical enclosure or electrical pod herein. The first container 302 includes a base and sidewalls that enclose a first volume. The second container 304 includes a base and sidewalls that enclose a second volume. The second container 304 is configured to be stacked above the first container 302 with the base of the second container 304 supported by the first container 302. In this arrangement, the power supply module 300 is a modular assembly, wherein the first container 302 forms a first storey of the modular assembly, and the second container 304 forms a second storey of the modular assembly.

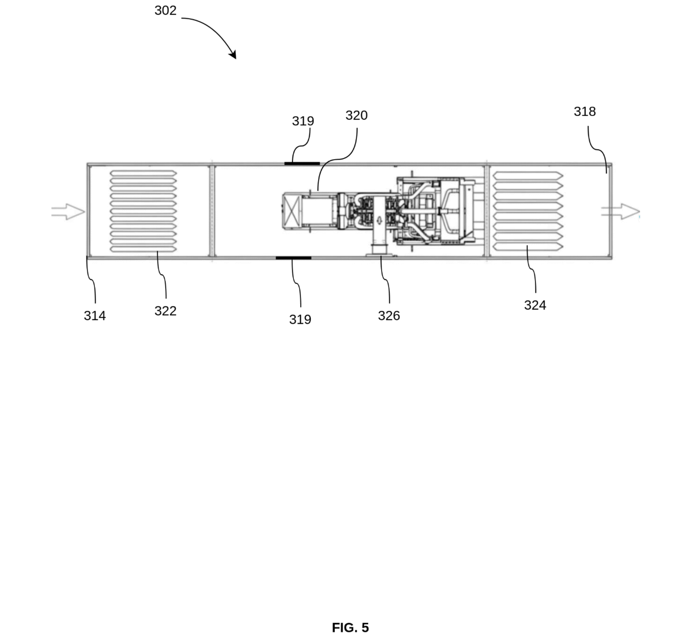

The first container 302 houses a generator unit within the first volume. The generator unit is configured to provide backup power to the modular data centre 100 when power from an external power supply, such as a utility or grid connection, fails. The first container 302 includes an air inlet having built in acoustic attenuation via a first acoustic louvre 314 at a first end of the power supply module 300, to act as an air inlet part of an air intake system as will be discussed in more detail in relation to FIG. 5.

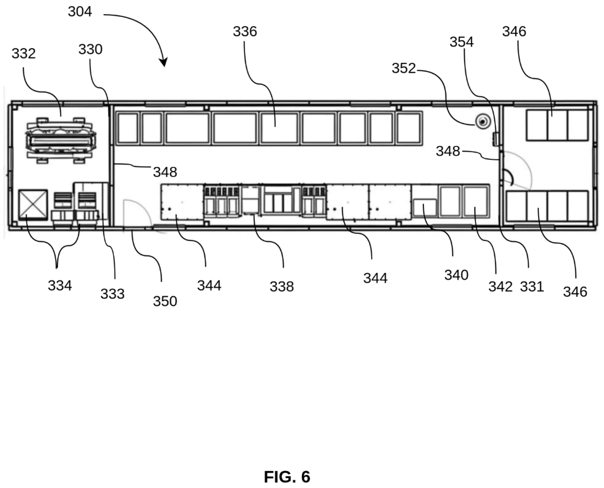

The second container 304 houses one or more electrical units within the second volume. The one or more electrical units are configured to receive power from an external power supply or from the generator unit and output the received power to the data hall 102 of the modular data centre 100, as will be discussed in more detail in relation to FIG. 6.

The base of the first container 302 and the base of the second container 304 have the same footprint. This matching footprint configuration provides a uniform vertical profile for the power supply module 300, with the second container 304 aligning directly above the first container 302 without overhang or offset. The aligned footprints facilitate structural support between the containers, as the load from the second container 304 is transferred directly through the structural frame of the first container 302 to the ground below. This configuration also enables efficient use of the available ground area and simplifies the stacking process during installation.

In general, the size of the container footprint may be any suitable size to enable the containers to house the generator unit / one or more electrical units. In some embodiments, the power supply module 300 footprint dimensions may be between approximately 2 to 10 meters wide by 10 to 20 meters long, preferably approximately 3.8 metres wide by 17.3 metres long, or approximately 3.8 metres wide by 21 metres long. In other embodiments, the power supply module 300 footprint dimensions are designed to approximate standard shipping container dimensions of roughly 2.4 metres wide by 12.2 metres long, to enable ease of transport using standard transportation equipment, including via rail and road.

As shown in FIG. 3, a fuel module 316 may be positioned beneath the first container 302. The fuel module 316 is configured to receive the first container 302 with the base of the first container 302 supported by the fuel module 316. The fuel module 316 provides a space for a fuel tank beneath the first container 302, as will be discussed in more detail later. The fuel module 316 may elevate the first container 302 above ground level, for example by up to 1 meter in some embodiments. In some embodiments, the fuel module 316 may be a separate component to the first container 302. In other embodiments, the fuel module 316 may be integral with the first container 302. Alternatively, in some embodiments the fuel module may be omitted altogether, with the base of the first container 302 positioned directly on the ground.

An exhaust unit 306 is disposed on a roof of the second container 304. The exhaust unit 306 is coupled to an exhaust outlet of the generator unit via an exhaust duct 308 that extends from the first container 302 and around the outside of the second container 304. The exhaust unit 306 may comprise a selective catalytic reduction (SCR) system or the like, to function as a catalytic converter for environmental cleanup of exhaust emissions from the generator unit. An exhaust silencer 309 may also be positioned along the exhaust duct 308 in some embodiments, to reduce noise from the generator exhaust system.

In some embodiments, the combined weight of the second container 304 and the exhaust unit 306 may be in excess of 53 to 55 tonnes. This substantial weight imposes significant structural requirements on the first container 302, which must be sufficiently robust to support the entire load of the second container 304 and its contents when stacked. The first container 302 may therefore be constructed with a reinforced structural frame, including strengthened corner posts and load-bearing members, designed to transfer the weight of the second container 304 to the fuel module 316 and/or ground foundation.

As shown in FIG. 3, the second container 304 may also include an external door 350 on one sidewall, providing access to the interior of the second container 304 for maintenance and servicing of the electrical units housed within. In the embodiment of FIG. 3, a staircase 310 extends along an outside wall of the first container 302, providing access into the second container 304 via the external door 350. Other access means such as ladders or the like may also be used. A walkway platform 312 with safety railings may be included around portions of the second container 304 at the upper level, facilitating maintenance access to the electrical equipment housed within the second container 304 and access to the exhaust unit 306 on the roof.

The first container 302 and the second container 304 may be constructed from metal or other suitable structural materials. The sidewalls of the containers may comprise steel panels or the like, which may be corrugated or ribbed to provide structural rigidity while minimising material weight. The steel panels may be galvanised or otherwise treated to provide corrosion resistance for outdoor installation. The structural frames of the containers, including corner posts, floor beams, and roof beams, may be constructed from structural steel sections sized to accommodate the loads imposed during transport, lifting, and stacking operations.

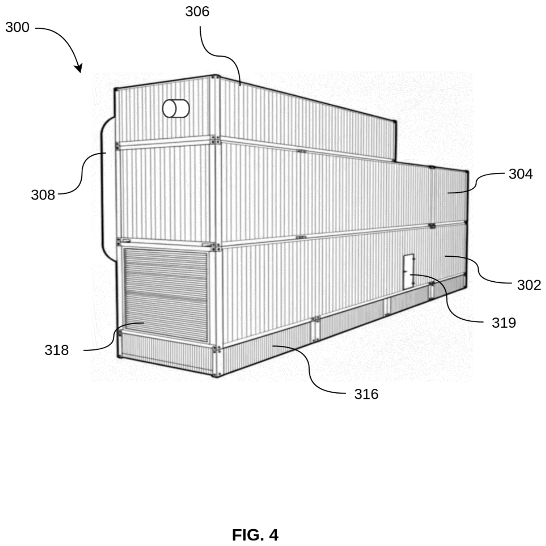

FIG. 4 illustrates a rear isometric view of the power supply module 300 of FIG. 3, viewed from the reverse direction.

An air outlet having a built in second acoustic louvre 318 is visible at a second end of the power supply module 300 in FIG. 4, forming part of an air discharge system to expel air from within the first container 302, as will be discussed in more detail in relation to FIG. 5.

The view in FIG. 4 further includes a cover over the exhaust unit 306 that encloses the components of the exhaust unit 306, such as the SCR system. Such a cover configuration is optional, and may be included to provide weather protection for the exhaust unit 306 and present a uniform external appearance for the power supply module 300 (as shown in FIGs. 2 and 4). In other embodiments, the cover may be omitted, as shown in FIG. 3.

An external door 319 may also be included on a sidewall of the first container 302, providing access to the interior of the first container 302 for maintenance and servicing of the generator unit.

FIG. 5 illustrates a plan view of the first container 302 showing the internal arrangement and layout of components within the first container 302 (generator enclosure).

The first container 302 comprises a first compartment, a second compartment and a third compartment arranged linearly along the length of the first container 302. The first compartment is located at a first end of the first container 302. The third compartment is located at a second end of the first container 302 opposing the first end. The second compartment is located between the first compartment and the third compartment.

The first compartment comprises an air intake system configured to draw air into the first container 302 (shown by the arrow on the left hand side of FIG. 5) for cooling a generator unit 320 within the first container. The air intake system may include an inlet ventilation attenuator 322 positioned within the first compartment. The inlet ventilation attenuator 322 is configured to attenuate noise from air entering the first container 302. The first acoustic louvre 314 is positioned at the end wall of the first container 302 adjacent to the inlet ventilation attenuator 322. The first compartment includes the first acoustic louvre 314 passing through a first end wall of the first container 302, providing an air intake opening through which cooling air is drawn into the first container 302. Air can then flow from the first compartment into the second compartment.

The second compartment contains the generator unit 320, and will also be referred to as a generator compartment herein. The generator unit 320 is positioned within the second compartment and is configured to provide backup power to the modular data centre 100, e.g. during failure of an external grid-based power supply. In some embodiments, the generator unit 320 may provide a power between 1.5MW and 10MW, preferably between 2MW and 5MW. In a specific embodiment, the generator unit 320 is a 2.4MW generator. The 2.4MW generator configuration is particularly beneficial because generators of this capacity are readily available, cost-effective, and mass produced. Further, a 2.4MW generator provides sufficient capacity to supply the 1.5MW of IT equipment power required by the associated portion of the data hall (the first power supply stream), together with an additional power (0.9MW in this embodiment) for powering plant equipment (i.e. equipment other than the IT equipment) such as cooling systems, lighting, and other mechanical infrastructure supporting the data centre operation (the second power supply stream).

The generator unit 302 may include both an engine portion and an electrical generator portion. Further, the generator unit may also include one or more radiator portions to help remove heat from the engine portion of the generator unit.

In some embodiments, the generator unit 320 may be mounted on dampers or the like for vibration attenuation and isolation. Such dampers attenuate vibrations generated during operation of the generator unit 320, reducing transmission of vibrations to the first container 302 and the surrounding structure of the power supply module 300.

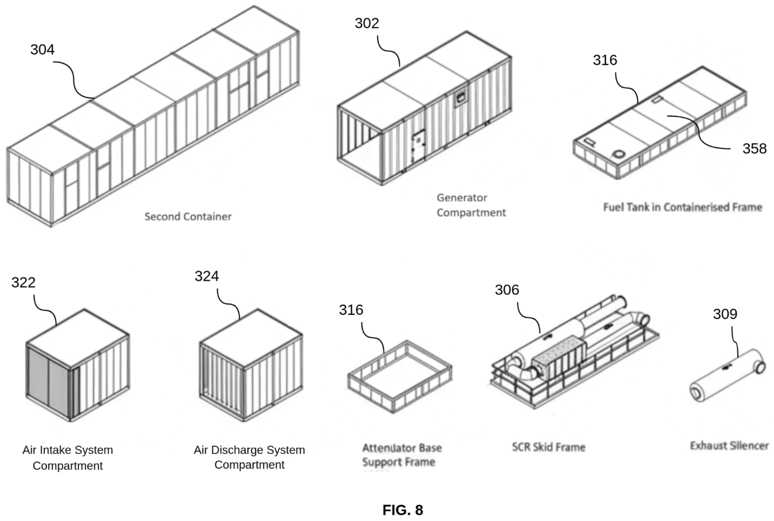

In some embodiments, the second compartment of the first container 302 may further include a fuel tank to provide fuel for the generator unit 320 (not shown in FIG. 5). Alternatively, the fuel tank for the generator unit may be located elsewhere. For example, in some embodiments the fuel tank may be positioned within the fuel module 316 beneath the first container 302, as will be described in more detail relation to FIG. 8. In other embodiments, the fuel tank may be a separate external above or below ground tank located away from (e.g. remote from) the power supply module 300. Such a fuel tank configuration may be advantageous where larger fuel storage capacity is required. Moreover, a larger separate external tank may be used to provide fuel to multiple power supply modules 300 in some embodiments, enabling a centralised fuel storage arrangement that serves multiple generator units across the modular data centre 100.

As shown in FIG. 5, an exhaust outlet 326 extends from the generator unit 320. The exhaust outlet 326 is configured to route exhaust gases from the generator unit 320 out of the first container 302. The exhaust outlet 326 may be connected to the exhaust unit 306 positioned above the second container 304 via exhaust duct 308, as described previously in relation to FIG. 3.

The third compartment of the first container 302 comprises an air discharge system configured to expel from the first container 302 the cooling air that has since been heated by the generator unit 320 (shown by the arrow on the right hand side of FIG. 5). In other words, heated air from the second compartment can flow into the third compartment. The air discharge system may include a discharge ventilation attenuator 324 positioned within the third compartment. The discharge ventilation attenuator 324 is configured to attenuate noise from air exiting the first container 302 after cooling the generator unit 320. The second acoustic louvre 318 is positioned at the end wall of the first container 302 adjacent to the discharge ventilation attenuator 324. The third compartment includes the second acoustic louvre 318 passing through a second end wall of the first container 302, providing an air discharge opening through which heated air is expelled from the first container 302.

In the embodiment of FIG. 5, the linear arrangement of the air intake system, the generator unit 320, and the air discharge system establishes an airflow path through the first container 302. Cooling air enters through the first acoustic louvre 314, passes over the engine portion and/or one or more radiator portions of the generator unit 320 to absorb heat, and exits through the second acoustic louvre 318. In general, the components of the air intake and air discharge systems may be located anywhere within the first container 302 provided that they create an airflow past the engine and/or one or more radiator portions of the generator unit 320. For example, in some embodiments the acoustic louvres 314 and 318 may be positioned at other locations within the sidewalls of the first container 302, rather than at the end walls of the first container 302.

In some embodiments, the one or more radiator portions may be positioned on the generator unit 320 directly adjacent to the air discharge system of the third compartment. Further, in some embodiments a sealing means could be provided around the one or more radiator portions of the generator unit 320, to ensure cooling air flows past the one or more radiator portions before entering the air discharge system of the third compartment.

As shown in FIG. 5, in some embodiments the first container 302 may include one or more external doors 319 through the sidewalls of the first container 302, providing access to the interior of the first container 302 for maintenance and servicing of the generator unit 320.

In some embodiments, the first container 302 may be formed from a plurality of container sections that couple together to form the first container 302. The container sections may be configured in various arrangements depending on manufacturing and transport requirements.

In one configuration, as shown in FIG. 5, the plurality of container sections correspond to the compartments of the first container 302. In this arrangement, a first container section houses the first compartment containing the inlet ventilation attenuator 322, a second container section houses the second compartment containing the generator unit 320, and a third container section houses the third compartment containing the discharge ventilation attenuator 324.

In an alternative configuration, the container sections are independent of the compartment arrangement. For example, the first container 302 may be formed from two container sections of equal length that couple together at a central location. This configuration provides flexibility in the sizing and positioning of the air intake compartment, generator compartment, and air discharge compartment independently of the structural divisions between container sections.

In some embodiments, once the container sections are coupled together to form the first container 302, the components within the first container 302 (such as the inlet ventilation attenuator 322, generator unit 320, and discharge ventilation attenuator 324) can be installed into or removed from the first container 302 via the end walls of the first container 302. For example, the first acoustic louvre 314 and/or and second acoustic louvre 318 may be removable to enable any of the components within the first container 302 to be removed, e.g. for maintenance.

FIG. 6 illustrates a floor plan view of the second container 304 showing an internal arrangement and layout of electrical components within the second container 304 (electrical pod) in a specific embodiment of the invention.

The second container 304 houses electrical distribution equipment configured to receive power from both the generator unit 320 housed within the first container 302 and a utility/grid supply, and distribute the power to the data hall 102. The second container 304 operates primarily from utility grid power whilst maintaining backup generation capacity from the generator unit 320 for use during grid outages or maintenance periods or the like. The second container 304 houses all of the electrical components for providing power to the respective portion of the data hall 102 that it is associated with, including the IT power required by that portion and ancillary (plant) power, such as for cooling.

In some embodiments, the second container 304 may include one or more internal walls to partition the second volume into a plurality of compartments. For example, in the embodiment of FIG. 6 the second container 304 is divided into three compartments by a first internal wall 330 and a second internal wall 331. Each compartment can be configured to house different electrical units, depending on the specific configuration of the electrical pod. In general, any number and layout of internal compartments may be used. Further in some embodiments internal walls may be omitted, such that the second container 304 has only one compartment (the second volume).

The embodiment of FIG. 6 includes a first compartment, a second compartment, and a third compartment. The third compartment is located at one end of the second container 304 and contains a transformer 332. The transformer 332 is configured for voltage conversion, receiving power from an external power supply such as a utility grid connection and converting the voltage to levels suitable for distribution within the modular data centre 100. For example, the transformer 332 may be a step down transformer, converting the high voltage external power supply to a lower voltage level before being passed to other electrical units within the second container 304. The third compartment further includes a ring main unit (RMU) 333 to facilitate the delivery of high voltage power from the external power supply to the transformer. Extraction fan equipment 334 may also be included in the first compartment to provide ventilation for the transformer compartment, removing heat generated by the transformer 332 during operation.

The first internal wall 330 separates the third compartment containing the transformer 332 from the second compartment. The second compartment forms the central electrical distribution area of the second container 304. In the specific embodiment shown in FIG. 6, a main switchboard 336 (first switchboard) is positioned within the second compartment and is configured to receive electrical power from the transformer 332 or receive power from the generator unit 320, and distribute the power downstream to IT equipment within the data hall 102 (in the first power supply stream). A second switchboard 342 is positioned within the second compartment and is configured to receive electrical power from the transformer 332 or receive power from the generator unit 320, and distribute the power to downstream to mechanical plant equipment within the data centre (in the second power supply stream). A first UPS 338 and a second UPS 340 are positioned in the second compartment to provide uninterruptible power supply to the data hall 102 in the event of a disruption to the external power supply. For example, the first UPS 338 and the second UPS 340 are configured to maintain continuous power supply during a failure of the external power supply, by providing power either until a transition between the external power supply and the generator unit 320 has completed, or until the external power supply is restored. Thus, the first UPS 338 and the second UPS 340 prevent interruption to the power supply for the computer systems or plant equipment within the data hall 102. The first UPS 338 may be associated with the main switchboard 336 to prevent a disruption in the power supplied to the IT equipment. The second UPS 340 may be associated with the second switchboard 342 to prevent a disruption in the power supplied to the plant equipment. In general, either of the first UPS 338 and second UPS 340 may include more than one UPS system.

The second internal wall 331 separates the second compartment from the first compartment. The first compartment is located at the opposite end of the second container 304 from the third compartment in the embodiment of FIG. 6. However as discussed, any suitable layout of compartments may be used within the second container 304. The first compartment contains one or more batteries 346. The batteries 346 provide backup power during transitions between the external power supply and the generator unit 320, e.g. during a failure of the external power supply.

The internal walls 330 and 331 may comprise an internal fire separation layer comprising a fire-retardant material, providing fire protection between the compartments within the second container 304. Such internal fire separation is particularly important for separating the battery compartment from other electrical equipment due to the fire risks associated with battery systems, particularly lithium-ion batteries which can present thermal runaway risks. By housing the batteries 346 in a dedicated compartment separated from other electrical units by fire-retardant internal walls, the risk of fire propagation from a battery incident to other critical electrical equipment can be reduced. Similarly, the fire separation protects the batteries 346 from fire events originating in other compartments of the second container 304, such as electrical faults in the switchboards or transformer.

The internal fire separation layer may be configured to provide a specific fire rating, such as a 1 hour, 2 hour, or 4 hour fire rating, depending on local fire regulations and the specific requirements of the data centre installation. The fire rating determines the duration for which the internal walls can maintain their structural integrity and prevent fire spread between compartments, providing time for fire suppression systems to activate and for firefighting teams to respond to a fire event.

In the embodiment of FIG. 6, computer room air handler (CRAH) units 344 are positioned along the length of the second compartment to provide cooling for the electrical equipment housed within. The CRAH units 344 maintain appropriate operating temperatures for the main switchboard 336, the first UPS 338, the second UPS 340, the second switchboard 342. In general, other such cooling units may be included in any compartment of the second container 302 as required.

As shown in FIG. 6, internal doors 348 may be included in the internal walls to provide access between compartments within the second container 304, e.g. for maintenance and operation. One or more external doors 350 may also be included to provide access to the second container 304 from outside (one specific layout of multiple external doors is shown in FIG. 3).

In some embodiments, specific fire safety equipment may be distributed throughout the second container 304. For example, in FIG. 6 fire suppression equipment 352 is provided within the second container 304 to protect the container in the event of a fire. The fire suppression equipment 352 may comprise automatic suppression systems configured to detect and suppress fires within the electrical compartments of the second container 304. Further, a fire alarm panel 354 monitors fire detection systems and provides alarm and control functions for fire safety within the second container 304.

The one or more electrical units within the second container 304 are configured to output a first power supply stream for IT equipment of the modular data centre 100, using power provided by either the external power supply (e.g. via the transformer) or the generator unit. In some embodiments, the first power supply stream is output via the main switchboard 336 (first switchboard). The first power supply stream may be output via a plurality of output terminals (included in the main switchboard 336), wherein each of the plurality of output terminals may be associated with a respective portion of IT equipment of the modular data centre 100, e.g. different IT equipment racks. In some embodiments, the first power supply stream is equal to 1.5MW.

Further, the one or more electrical units within the second container 304 may be further configured to output a second power supply stream for plant equipment of the modular data centre 100. In some embodiments, the second power supply stream is output via the second switchboard 342. The second power supply stream provides power for heating/cooling systems, ventilation systems, lighting, and other mechanical infrastructure supporting the data centre operation. In some embodiments, the second power supply stream is equal to 0.9MW.

It is noted that although one specific arrangement of electrical units and one specific power distribution scheme has been described above in relation to FIG. 6, various other arrangements of electrical units may be housed in the second container 304 in other embodiments.

The stacked configuration of the power supply module 300, with the second container 304 positioned above the first container 302, provides advantageous alignment with the electrical distribution infrastructure within the data hall 102. In typical data centre configurations, power distribution equipment and cabling are routed along the ceiling of the data hall, for example at a height of approximately 6 metres above floor level. By positioning the second container 304 at an elevated level above the first container 302, the electrical outputs from the second container 304 are located at a height that corresponds to the ceiling-level distribution infrastructure within the data hall 102. This alignment reduces the vertical distance that power cables must traverse between the electrical units and the ceiling-mounted distribution equipment within the data centre, simplifying cable routing and reducing cable lengths. Furthermore, in multi-storey data centre configurations, the elevated position of the second container 304 provides a shorter cable path to upper floors of the data hall 102, reducing cable losses and installation complexity when serving IT equipment located on floors above ground level.

In some embodiments, the one or more electrical units within the second container 304 may further include one or more load bank connection terminals. The load bank connection terminals enable connecting of an external load bank to enable testing of the electrical infrastructure within the second container 304. The load bank connection terminals may be located on the outside of the first or second container 304,304 or may be located within the second container 304, with a weatherproof opening provided in the second container 304 to enable cables to pass into the container 304.

In some embodiments, the second container 304 comprises a plurality of container sections that couple together to form the second container 304. The plurality of container sections may correspond to the compartments of the second container 304. In this arrangement, a first container section houses the first compartment containing the batteries 346, a second container section houses the second compartment containing the first UPS 338, the second UPS 340, and the main switchboard 336 etc, and a third container section houses the third compartment containing the transformer 332 and RMU 333. The container sections couple together to form the complete second container 304.

In embodiments where the second container 304 is formed from a plurality of container sections, the one or more internal walls may be formed by the couplings between the plurality of container sections. Specifically, each container section may be provided with the internal walls forming the outer walls of that section, such that when two or more container sections are connected together to form the second container 304, the outer walls of adjacent sections become the internal walls separating the compartments within the assembled second container 304. A layer of fire-retardant material may be positioned between the coupled container sections of the second container 304 to form the internal fire separation layer in the internal walls, providing fire protection between the compartments. This configuration enables the internal fire separation walls to be integrated into the structural connections between container sections, simplifying construction while maintaining fire separation requirements.

In an alternative configuration, the container sections are independent of the internal compartment arrangement. In this arrangement, the second container 304 may be formed from two or more container sections that couple together, with the internal partitioning into compartments being performed after the container sections are coupled together. For example, the second container 304 may be formed from two container sections of equal length having open ends that couple together at a central location, with internal walls subsequently installed to define the first, second and third compartments as described above. This configuration provides flexibility in the sizing and positioning of internal compartments independently of the structural divisions between container sections.

Such sectional construction of the second container 304 is particularly advantageous given the substantial weight of the electrical units housed within which can make transportation of the fully assembled second container 304 challenging or impractical in some circumstances. By constructing the second container 304 from a plurality of container sections that couple together, each individual section can be transported separately with its associated electrical equipment already installed, reducing the weight of each transportable unit to within practical limits for road, rail, or other transportation methods. This sectional approach enables the second container 304 to be shipped in parts to the installation site, where the container sections are coupled together to form the complete second container 304 before or during stacking above the first container 302. Furthermore, the sectional construction allows removal of one section for maintenance without removal of the remaining sections, for example enabling just the third section containing the transformer 332 to be removed and/or replaced whilst the first and second sections remain in position.

In general, the first container 302 (e.g. the embodiment of FIG. 5) and the second container 304 (e.g. the embodiment of FIG. 6) may each be pre-commissioned and pre-tested off-site in a factory environment (whether in sections or as a completed container) before delivery to the installation site. This off-site commissioning approach ensures that the generator unit 320 and the electrical units housed within the containers are functional and verified before arrival at site, reducing the risk of on-site commissioning issues and enabling rapid deployment of the power supply module 300.

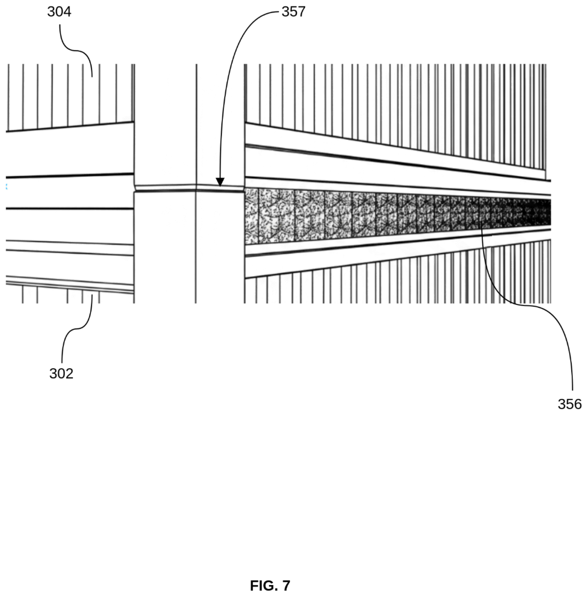

FIG. 7 illustrates a detailed view of a coupling region between the first container 302 and the second container 304 of the power supply module 300, in some embodiments. The view shows the structural arrangement at the interface where the second container 304 is stacked above the first container 302.

As shown in FIG. 7, in some embodiments a fire separation layer 356 may be disposed between the first container 302 and the second container 304, in a gap between the top surface of the first container 302 and the base of the second container 304. The fire separation layer 356 comprises a fire-retardant material. The fire separation layer 356 extends across the width of the containers and provides fire protection between the generator unit housed in the first container 302 and the electrical units housed in the second container 304. The fire separation layer 356 may comprise any fire-retardant material, e.g. of mineral wool or calcium silicate or the like. The fire separation layer 356 may be configured to provide a specific required fire rating, such as a 2 hour or 4 hour fire rating, as required by local fire regulations or specific requirements for the data centre.

As shown in FIG. 7, in some embodiments the stacking of the first container 302 and the second container 304 with the fire separation 356 therebetween may be facilitated via docking elements 357, as will be described in more detail later.

In some embodiments, the fire separation layer 356 is configured to be removable in a direction perpendicular to the stacking direction of the first container 302 and the second container 304 (e.g. by sliding out from between the containers 302,304 in the rightwards direction in FIG. 7. This removable configuration enables the fire separation layer 356 to be slid in and out from the side of the power supply module 300 without requiring disassembly of the stacked container arrangement. Such a fire separation layers 356 will typically have a shorter lifespan than the first and second containers 302,304 or the generator unit and electrical units housed within the containers. The removable configuration of the fire separation layer 356 therefore facilitates replacement of the fire separation layer 356 during the operational lifetime of the power supply module 300 without requiring the unstacking of the second container 304 from the first container 302.

In some embodiments, the slot or gap between the first container 302 and the second container 304 through which the fire separation layer 356 is inserted may include a cover (weather protection element) configured to protect the fire separation layer 356 from weather and environmental exposure. Such a cover may be positioned over the exposed edge of the fire separation layer 356 to prevent ingress of rain, debris, or other contaminants that could degrade the fire-retardant properties of the fire separation layer 356 over time. One embodiment of such a cover (weather protection element) configuration will be described in more detail later.

FIG. 8 illustrates an exploded isometric view of the main components of the power supply module 300 of FIGs. 3 to 7, showing the individual modular elements separated to demonstrate how the components assemble to form the complete power supply system.

At the top left of FIG. 8, the second container 304 is shown in completed form (i.e. either when only forms from one section, or after the multiple sections forming the second container 304 has been coupled together). As described previously, the second container 304 is configured to house the one or more electrical units, and these may be preinstalled within the second container 304 or sections of the second container 304 before installation at the data centre site.

At the top centre of FIG. 8, a second section of the first container 302 is shown, corresponding to the second compartment (generator compartment) of FIG. 5. As described previously, the second compartment of the first container 302 is configured to house the generator unit 320, and this may be preinstalled within the first container 302 or second section of the first container 302 before installation at the data centre site.

At the top right of FIG. 8, a section of the fuel module 316 is shown. This section of the fuel module 316 is configured to receive the second section (generator compartment) of the first container 302 with the base of the second section supported by the fuel module 316. Although shown as a separate component in FIG. 8, as mentioned above, in other embodiments the fuel module 316 may be integral with the first container 302. Further, in other embodiments the fuel module may be omitted altogether.

In some embodiments, as shown in the top right of FIG. 8, a fuel tank 358 for the generator unit 320 may be positioned within the fuel module 316 beneath the first container 302. The fuel tank 358 is configured to store fuel for the generator unit 320 housed in the first container 302. Such a fuel tank may be referred to as a belly tank due to its location at the underside of the first container 302. Thus fuel module 316 supports the base of the first container 302 whilst simultaneously housing the fuel tank 358 within the structural framework. This integrated arrangement positions the fuel tank 358 directly beneath the generator unit 320, minimising the length of fuel supply lines between the fuel tank 358 and the generator unit 320, whilst advantageously storing the large weight of fuel required at the lowest level of the power supply module 300. In some embodiments, such a fuel tank 358 may be configured to provide up to 48 hours of fuel storage, enabling extended operation during utility grid outages without requiring external fuel delivery.

In some embodiments, a fire separation layer may be disposed between the upper surface of the fuel module 316 and the base of the first container 302. This fire separation layer provides fire protection between the fuel tank 358 housed within the fuel module 316 and the generator unit 320 housed within the first container 302 above. In embodiments where the fuel module 316 is integral with the first container 302, the fire separation layer may be positioned within the integrated fuel module structure beneath the floor of the first container 302. The fire separation layer may comprise a fire-retardant material such as mineral wool or calcium silicate, and may be configured to provide a specific fire rating as required by local fire regulations or the specific requirements of the data centre installation.

As discussed previously in relation to FIG. 5, alternative fuel tank configurations may be employed. In some embodiments, the fuel tank 358 may be located within the first volume of the first container 302 rather than within the fuel module 316. In other embodiments, the fuel tank 358 may be a separate external tank located away from the power supply module 300, such as an above or below ground fuel storage tank. The selection of fuel tank configuration depends on factors including required fuel storage capacity, local regulations, and whether centralised fuel storage serving multiple power supply modules 300 is preferred.

In the bottom row of FIG. 8, a first section of the first container 302 is shown, corresponding to the first compartment (air intake system compartment) of FIG. 5. As described previously, the first compartment of the first container 302 may contain the inlet ventilation attenuator 322 and first acoustic louvre 314, and these may be preinstalled in the first container 302 or first section of the first container 302 before installation at the data centre site.

Further, second to the left in the bottom row of FIG. 8, a third section of the first container 302 is shown, corresponding to the third compartment (air discharge system compartment) of FIG. 5. As described previously, the third compartment of the first container 302 may contain the discharge ventilation attenuator 322 and second acoustic louvre 318, and these may be preinstalled in the first container 302 or third section of the first container 302 before installation at the data centre site.

In the configuration shown in FIG. 8, the air intake system compartment and the air discharge system compartment are provided as separate modular units that couple to the generator compartment of the first container 302 during assembly. This modular configuration enables the air intake system compartment, generator compartment, and the air discharge system compartment to be manufactured, transported, and installed as discrete sections, providing flexibility in the assembly sequence and enabling straightforward replacement of individual sections of the first container 302.

Although not shown in FIG. 8, such a sectional modular approach may also be used for sections of the second container 304.

In the middle of the bottom row of FIG. 8, an additional section of the fuel module 316 is shown. This section of the fuel module 316 is configured to receive the first or third sections of the first container 302 with the base of the first/third section supported by the fuel module 316. Although the fuel module 316 is shown with separate sections in FIG. 8, in other embodiments the fuel module 316 may be a single component that can support each of the first, second and third sections of the first container 302 whilst providing space for a fuel tank to be located beneath the first container 302.

In the bottom right of FIG. 8, the exhaust unit 306 and exhaust silencer 309 are shown, the exhaust unit includes selective catalytic reduction system mounted on a structural skid frame, to treat exhaust gases from the generator unit 320 before discharge to atmosphere. As described previously, the exhaust unit 306 is configured to be disposed on the roof of the second container 304 and coupled to the exhaust outlet 326 of the generator unit 320 via the exhaust duct. The exhaust silencer 309 may be positioned along the exhaust duct 308 between the exhaust outlet 326 of the generator unit 320 and the exhaust unit 306, to reduce noise from the exhaust system.

In the embodiment of FIGs. 3 to 8, the exhaust unit 306 has an outlet to expel the exhaust gases at the second end of the power supply module 300 above the second acoustic louvre 318. However, other exhaust configurations are also possible. For example, in the alternative configuration shown in FIG. 2, the exhaust unit is configured to expel gasses through a vertical exhaust flue above the first end of the power supply module 300.

The exploded view of FIG. 8 demonstrates the modular construction of the power supply module 300, wherein each component may be constructed a discrete transportable unit that is manufactured off-site in a controlled factory environment and assembled on-site at the data centre installation. The components shown in FIG. 8 collectively form a kit of parts for the power supply module 300.

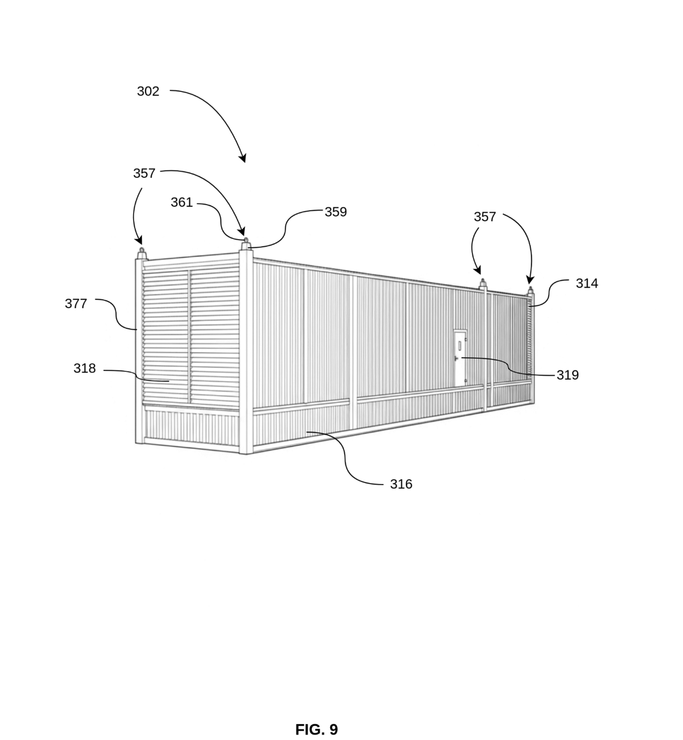

FIG. 9 illustrates a perspective view of the first container 302 for housing the generator unit of the power supply module 300. In the embodiment of FIG. 9, the first container 302 includes the fuel module 316, however, the fuel module may be omitted in other embodiments. The first acoustic louvre 314 can be seen positioned on one side wall of the first container 302 for inlet air ventilation, and the second acoustic louvre 318 is positioned on another side wall at the end of the first container 302 for discharge air ventilation, as described previously. An external door 319 is provided on a side wall of the first container 302 to enable access to the interior of the first container 302.

As shown in FIG. 9, a plurality of docking elements 357 are disposed at corners of the first container 302. A docking element 357 is also disposed along one side of the first container 302, positioned at an intermediate point along the length of the first container 302 to provide additional support for the second container 304 when stacked.

The docking elements 357 can be integrated with structural columns 377 of the first container 302 to provide load transfer points to support the weight of the second container 304 when stacked. The structural columns 377 extend vertically at the corners of the first container 302 and at positions along the side of container 302 and are configured to transfer the load from the second container 304 through the first container 302 to the ground below. By integrating the docking elements 357 with the structural columns 377, the substantial weight of the second container 304 and its contents, which may exceed 50 tonnes, is distributed through the primary load-bearing members of the first container 302 rather than through the sidewalls or roof structure. This integration ensures that the stacked container arrangement maintains structural integrity under the combined weight of the electrical equipment, transformer, batteries, and other components housed within the second container 304.

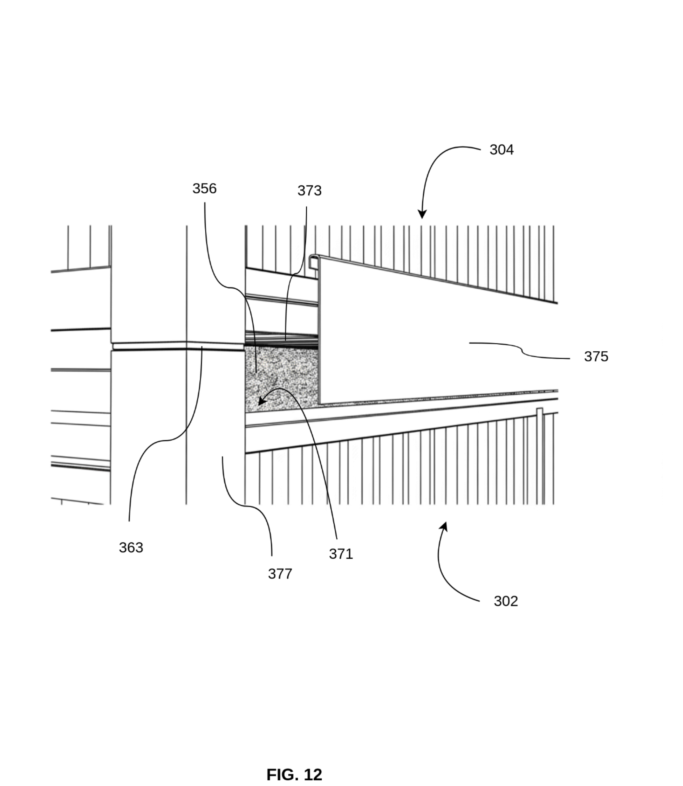

Furthermore, by transferring the load through the structural columns 377 rather than through the roof structure of the first container 302, a gap can be created between the top surface of the first container 302 and the base of the second container 304. This gap accommodates the fire separation layer 356 between the containers, as discussed in relation elsewhere, in particular with respect to FIGs. 7 and 12.

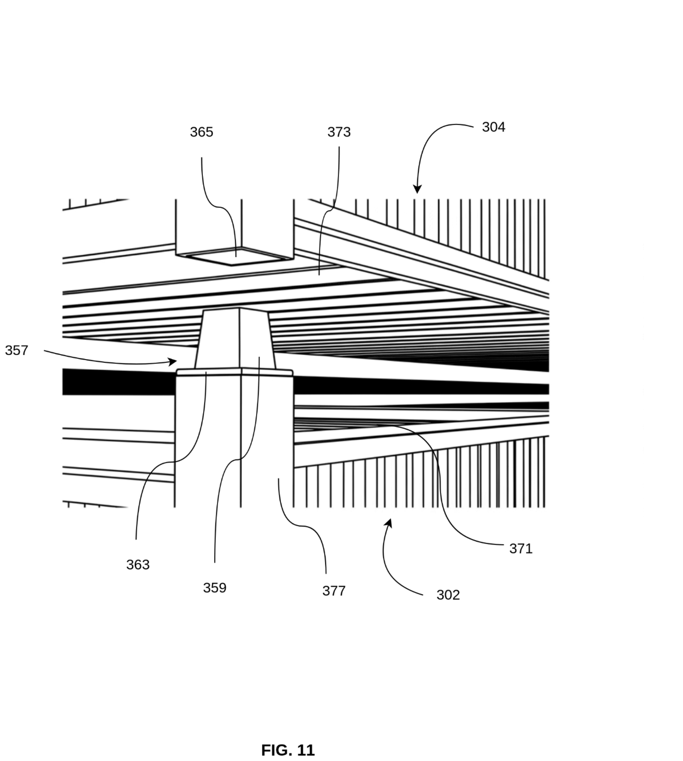

A locator plug 359 extends upwardly from each docking element 357 to facilitate alignment with the second container 304 during stacking. The locator plugs 359 are configured to engage with corresponding receiver elements on the second container 304, as discussed further in relation to FIG. 11, guiding the second container 304 into the correct position as the second container 304 is lowered onto the first container 302 during installation.

Each docking element 357 can also include a lifting eye 361, as illustrated in FIG. 9, to enable the first container 302 to be lifted and positioned during installation. The lifting eyes 361 are configured to receive lifting equipment such as crane hooks or shackles, enabling the first container 302 to be lifted from above during transport and installation operations. In some embodiments, the lifting eyes 361 are removable from the docking elements 357 after installation of the first container 302 at the data centre site. Such removable lifting eyes 361 may be removed after installation to prevent interference with the stacking of the second container 304 or other components.

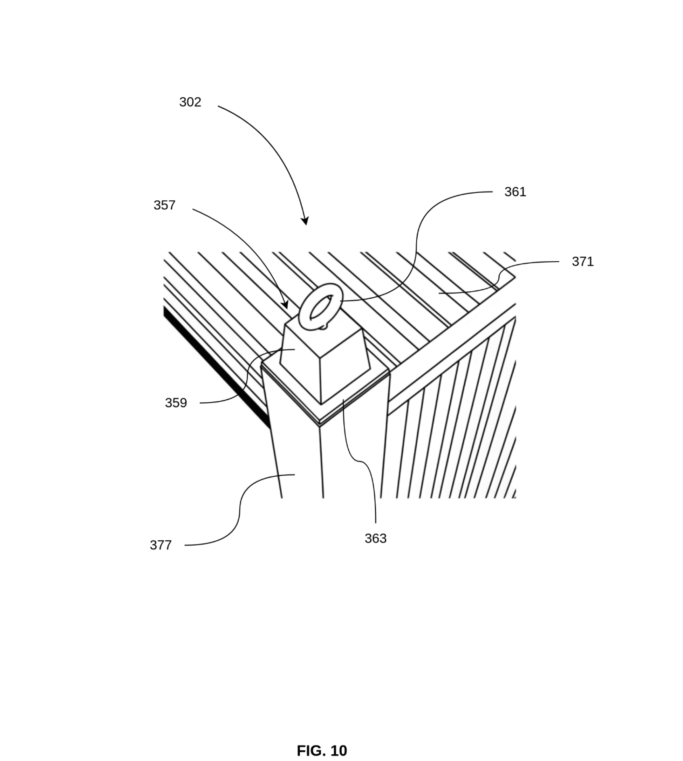

FIG. 10 illustrates a detailed perspective view of a corner of the first container 302, showing the docking arrangement components. A structural column 377 forms the structural corner post of the first container 302. The docking element 357 is disposed at the corner of the first container 302, with the locator plug 359 extending upwardly from the docking element 357 to facilitate alignment with the second container 304 during stacking.

The locator plug 359 may be configured with a tapered or chamfered upper portion to facilitate engagement with the corresponding receiver element on the second container 304. This tapered configuration enables the locator plug 359 to guide the second container 304 into alignment even when there is minor positional offset during the lowering operation, with the angled surfaces of the locator plug 359 directing the receiver element into the correct position as the second container 304 descends.

The lifting eye 361 is mounted on the docking element 357 to enable the first container 302 to be lifted by crane or similar lifting equipment during transportation and installation operations. The lifting eye 361 is configured to receive lifting hooks or shackles, enabling the first container 302 to be lifted from above. As described previously, in some embodiments the lifting eye 361 is removable from the docking element 357 after installation of the first container 302 at the data centre site. For example, the lifting eye 361 may be removably attached to the docking element 357 by a threaded portion of the lifting eye 361, enabling the lifting eye 361 to be unscrewed from docking element 357 to remove the lifting eye 361.

A vibration isolation element 363 may be positioned on the docking element 357, as illustrated in FIG. 10. The vibration isolation element 363 is configured to reduce transmission of vibrations from the generator unit 320 housed within the first container 302 to the second container 304 when the second container 304 is stacked on the first container 302. The vibration isolation element 363 may comprise an elastomeric material or other vibration-dampening material positioned between the docking element 357 and the corresponding receiver element of the second container 304. During operation of the generator unit 320, vibrations may be generated that propagate through the structure of the first container 302. The vibration isolation element 363 attenuates these vibrations at the interface between the first container 302 and the second container 304, reducing the transmission of vibrations to the electrical units housed within the second container 304. This vibration isolation protects the electrical equipment from potential vibration-induced damage or malfunction.

A top surface 371 of the first container 302 is visible at the top of the corner in FIG. 10. The top surface 371 is configured to interface with the docking arrangement. As described previously in relation to FIG. 7, a gap is created between the top surface 371 of the first container 302 and the base of the second container 304 when the second container 304 is stacked on the first container 302. This gap accommodates the fire separation layer 356 between the containers.

The structural framework of the power supply module 300 comprises the structural columns 377 at the corners, and optionally also at positions along the sides of the first container 302, that can be interconnected by horizontal beams to form a rigid structural framework. This frame structure provides structural integrity for the power supply module 300 while distributing the loads from the stacked second container 304 through the primary load-bearing members. The frame configuration enables the power supply module 300 to function as a modular assembly, wherein the first container 302 forms a first storey of the modular assembly and the second container 304 forms a second storey of the modular assembly, as described previously in relation to FIG. 3.

FIG. 11 illustrates a detailed view of the docking arrangement between the first container 302 and the second container 304 as the second container 304 is in the process of being stacked on the first container 302. The second container 304 is shown positioned above the first container 302, with a base 373 of the second container 304 visible at the upper portion of the view above top surface 371 of the first container 302.

A receiver element 365 is disposed at a corner of the second container 304. The receiver element 365 is configured as a recess to receive the docking components from below. The locator plug 359 extends upwardly from the docking element 357, which is disposed at a corner of the first container 302. The locator plug 359 engages with the receiver element 365 when the second container 304 is stacked on the first container 302, guiding the second container 304 into the correct position during installation.

The receiver element 365 may be chamfered to facilitate alignment with the locator plug 359 during stacking, or otherwise matched to the shape of the locator plug 359. This configuration of the receiver element 365 provides a tapered entry that guides the locator plug 359 into the receiver element 365 as the second container 304 is lowered onto the first container 302. This arrangement compensates for minor misalignments during the stacking operation, enabling the second container 304 to self-centre as the second container 304 is lowered into position.

The vibration isolation element 363 is positioned on the docking element 357 to reduce transmission of vibrations from the generator unit 320 housed in the first container 302 to the second container 304. The vibration isolation element 363 functions as an isolation pad between the containers to accommodate differential movement caused by generator vibration during operation. The receiver element 365 may be sized so as to permit limited relative movement between the second container 304 and the first container 302 to accommodate vibrations of the generator unit 320 during use and relive stresses in the joint.

The structural column 377 forms the structural corner post of the first container 302. The top surface 371 of the first container 302 is visible, with a gap created between the top surface 371 and the base 373 by the height of the docking element 357. This gap is configured to receive the fire separation layer 356 between the two containers when stacked, as described previously in relation to FIG. 7.

In some embodiments, the docking system is configured as a free connection relying on the dead weight of the upper container to keep the upper container in place rather than a fixed connection. In this configuration, the weight of the second container 304 resting on the docking elements 357 maintains the stacked arrangement without requiring mechanical fasteners or locking mechanisms. This free connection configuration enables a very quick and easy deployment and assembly of a power supply module 300, and also helps accommodate any differential movement between the first container 302 and the second container 304, such as may be caused by vibrations from the generator unit 320 during operation.

In some cases, the docking system includes a securing mechanism to secure the second container 304 on the first container 302 in the stacked position. In some cases, this may include a latching mechanism, or a screw mechanism that tightens against a contact pad on the locator plug 359 to lock the containers together. The screw mechanism may comprise a threaded fastener that is tightened to press against the locator plug 359, creating a friction-based connection that secures the second container 304 to the first container 302. This screw locking mechanism provides a fixed connection between the containers when required, for example in installations where additional structural stability is needed or where local regulations require mechanical fastening of stacked structures.

In some embodiments, the docking element 357 comprises a locator plug 359 extending upward from the first container 302 to engage with the second container 304, as illustrated in FIGs. 9 to 11. In alternative embodiments, the docking element may comprise a recess extending downward in the first container 302 to engage with a corresponding locator plug on the second container 304. This embodiment may be substantially the same as that described with respect to FIGs. 9 to 11, except with the docking system reversed. Both configurations may achieve the same alignment and support functions, with the selection of configuration depending on manufacturing and installation preferences.

In some embodiments, the docking element 357 is configured to accommodate a mount for a rail system, such as a unistrut cladding rail system, for attaching external cladding panels. The docking element 357 may include mounting features that receive unistrut channels or similar cladding rail components, enabling external cladding panels to be attached directly to the docking elements 357. This integrated cladding support configuration enables the docking element 357 to perform dual functions of supporting the stacked container arrangement and providing attachment points for external cladding.

The power supply module 300 may include screening cladding for visual screening from neighbouring properties when positioned on the perimeter of a data centre site. The screening cladding may be attached to the unistrut cladding rail system supported by the docking elements 357, providing an external finish that screens the power supply module 300 from view. This screening cladding configuration addresses planning requirements for data centre installations located in proximity to neighbouring buildings or public areas.

In embodiments where the second container 304 comprises a plurality of container sections, the second container sections are arranged adjacent to one another horizontally, with each independently stacked and supported by corresponding docking elements 357 on the first container 302, for example with back-to-back docking elements 357 along the edges where sections of the second container 304 meet.

FIG. 12 illustrates a detailed view of the stacked container arrangement with the first container 302 and the second container 304 positioned one above the other. The structural column 377 forms the structural corner posts of the power supply module 300. The vibration isolation element 363 is visible on the docking arrangement in the specific embodiment of FIG. 12, to reduce transmission of vibrations between the containers as described previously in relation to FIGs. 10 and 11. Such a vibration isolation element 363 may be omitted in other embodiments.

A gap between the top surface 371 of the first container 302 and the base 373 of the second container 304 is formed by the height of the docking elements 357. The docking elements 357 extend upwardly from the top surface 371 of the first container 302, and when the second container 304 is stacked on the first container 302, the base 373 of the second container 304 rests on the docking elements 357 rather than directly on the top surface 371. This arrangement creates a gap between the top surface 371 and the base 373, with the height of the gap determined by the vertical extent of the docking elements 357 above the top surface 371. In some cases, the gap can alternatively be created by the corner columns of the second container 304 extending down below the base 373 of the second container 304, or through some combination thereof.

In some embodiments, the gap is at least 100mm, at least 150mm, at least 200mm, or at least 250mm, depending on the thickness of the fire separation layer 356 to be accommodated and any additional clearance required for installation and removal of the fire separation layer 356. The docking elements 357 are positioned at the corners of the first container 302, and optionally at intermediate positions along the sides of the first container 302, such that the gap extends substantially across the entire interface between the first container 302 and the second container 304, enabling the fire separation layer 356 to be inserted into the gap from the side of the power supply module 300. With docking elements 357 at intermediate positions along the sides of the first container 302, the fire separation layer 356 may be provided in one or more parts to enable insertion and removal.

As described previously in relation to FIG. 7, the fire separation layer 356 comprises a fire-retardant material and is disposed between the first container 302 and the base 373 of the second container 304 when stacked. The fire separation layer 356 is positioned in the gap between the top surface 371 of the first container 302 and the base 373 of the second container 304 to provide fire resistance and thermal protection between the generator unit container below and the electrical equipment container above.

In some embodiments, the fire separation layer 356 provides a 2 hour fire rating. In other embodiments, the fire separation layer 356 provides a 4 hour fire rating. The fire rating determines the duration for which the fire separation layer 356 maintains structural integrity and prevents fire spread between the first container 302 and the second container 304, providing time for fire suppression systems to activate and for personnel to respond to a fire event, and is a function of the material used in the fire separation layer 356 and the thickness of the fire separation layer 356.

The fire separation layer 356 is configured to be removable and replaceable. This can be beneficial as a fire separation layer 356 may have a typical service life which is shorter than the service life associated with the electrical equipment housed within the second container 304. This difference in service life means that the fire separation layer 356 may require replacement during the operational lifetime of the power supply module 300. The removable configuration of the fire separation layer 356, as described previously in relation to FIG. 7, enables the fire separation layer 356 to be slid out from between the containers 302, 304 and replaced without requiring disassembly or even replacement of the stacked container arrangement.

As shown in FIG. 12, a weather protection element 375 is positioned to provide weather protection to the fire separation layer 356 and prevent moisture ingress or environmental degradation of the fire separation material. The weather protection element 375 typically can be attached and removed without tools, facilitating access to the fire separation layer 356 for inspection or replacement. For example, the weather protection element 375 may comprise a lip that clips onto an edge or ridge of the second container 304.

The weather protection element 375 covers the exposed edge of the fire separation layer 356 where the fire separation layer 356 is accessible from the exterior of the power supply module 300. The weather protection element 375 prevents ingress of rain, snow, debris, or other contaminants that could degrade the fire-retardant properties of the fire separation layer 356 over time. By protecting the fire separation layer 356 from moisture, the weather protection element 375 extends the service life of the fire separation layer 356 and maintains the fire rating of the fire separation layer 356 throughout the operational period between replacements.

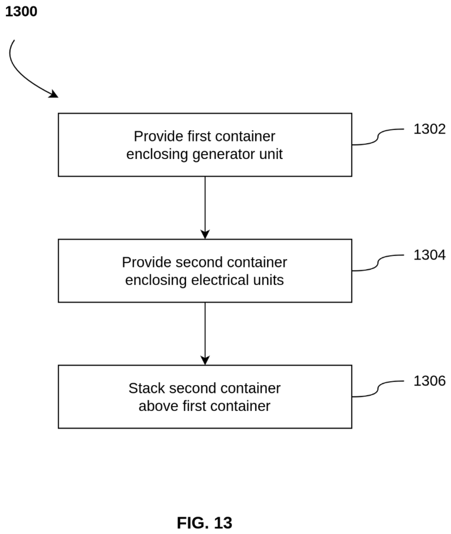

FIG. 13 illustrates a flowchart of a method 1300 for constructing a power supply module for a modular data centre, such as the power supply module 300. The method 1300 provides an approach for assembling the power supply module 300 from discrete modular components.

The method 1300 begins with a step 1302 of providing a first container, such as the first container 302 discussed previously.

The method 1300 proceeds to a step 1304 of providing a second container, such as the second container 304 discussed previously.

The method 1300 concludes with a step 1306 of stacking the second container above the first container with the base of the second container supported by the first container, e.g. at the installation site. As described previously in relation to FIGs. 3 and 4, the second container 304 is positioned above the first container 302 such that the base of the second container 304 rests upon and is supported by the first container 302. The stacking may be achieved using the docking element 357 described previously, which provides structural connection between the stacked containers while accommodating the fire separation layer 356. The fire separation layer 356 may be disposed between the first container 302 and the second container 304 during the stacking step 1306.

In some embodiments, the method 1300 further comprises coupling the second container 304 to the first container 302 during or after the stacking. The coupling may be performed using the docking elements as discussed in FIGs. 9 to 12.

After the stacking, the power supply module 300 may be connected to the data hall 102 of the modular data centre 100 to provide electrical power. Electrical cables are routed from the one or more electrical units housed within the second container 304 to electrical distribution equipment within the data hall 102 via the cable routing infrastructure 120 described previously in relation to FIG. 2. The cable routing infrastructure 120 may carry both power cables for delivering electrical power to the IT equipment and plant equipment within the data hall 102, and control cables for monitoring and control functions. Additionally, the power supply module 300 is connected to an external power supply, such as a utility or grid connection, which provides the primary source of electrical power during normal operation. The generator unit housed within the first container 302 is connected to a fuel supply, e.g. from the fuel tank 358, to enable backup power generation when the external power supply fails.

In some embodiments, providing the first container 302 in step 1302 further comprises providing a plurality of first container sections and coupling the plurality of first container sections together to form the first container 302. For example, the first container 302 may comprise three container sections corresponding to the first compartment containing the inlet ventilation attenuator 322, the second compartment containing the generator unit 320, and the third compartment containing the discharge ventilation attenuator 324, as described previously in relation to FIG. 5.

Similarly, in some embodiments, providing the second container 304 in step 1304 further comprises providing a plurality of second container sections and coupling the plurality of second container sections together to form the second container 304. As described previously in relation to FIG. 6, the second container 304 may comprise a plurality of container sections that couple together to form the second container 304.

The modular construction approach of the method 1300 enables the power supply module 300 to be manufactured off-site in a controlled factory environment and delivered to site as pre-assembled and pre-tested components (i.e. either the first and second containers 302, 304 in their entirety, or in sections as the first and second container sections). The individual containers and container sections are configured as discrete transportable units that can be transported to site using standard transportation equipment and assembled on-site at the data centre installation.

Features of any of the examples or embodiments outlined above may be combined to create additional examples or embodiments without losing the intended effect. It should be understood that the description of an embodiment or example provided above is by way of example only, and various modifications could be made by one skilled in the art. Furthermore, one skilled in the art will recognise that numerous further modifications and combinations of various aspects are possible. Accordingly, the described aspects are intended to encompass all such alterations, modifications, and variations that fall within the scope of the appended claims.
The following clauses set out certain combinations of features contemplated by the present disclosure.
Clause 1. A power supply module for a modular data centre, the power supply module comprising:
   a first container including a base and sidewalls, wherein the first container encloses a first volume;
   a generator unit located within the first volume;
   a second container including a base and sidewalls, wherein the second container encloses a second volume, and wherein the second container is configured to be stacked above the first container with the base of the second container supported by the first container; and
   one or more electrical units located within the second volume, said one or more electrical units configured to receive power from an external power supply or from the generator unit and configured to output power to a data hall of the modular data centre.
Clause 2. The power supply module of clause 1, wherein the one or more electrical units are configured to receive power from the generator unit during a failure of the external power supply.
Clause 3. The power supply module of clauses 1 or 2, wherein the external power supply is a utility power supply or a grid power supply.
Clause 4. The power supply module of any preceding clause, wherein the base of the first container and the base of the second container have the same footprint.
Clause 5. The power supply module of any preceding clause, further comprising a fire separation layer comprising a fire-retardant material, said fire separation layer disposed between the first container and the base of the second container when stacked.
Clause 6. The power supply module of clause 5, wherein the fire separation layer is removable in a direction perpendicular to the stacking direction of the first and second containers.
Clause 7. The power supply module of any preceding clause, further comprising an exhaust unit disposed on a roof of the second container, said exhaust unit coupled to an exhaust outlet of the generator unit.
Clause 8. The power supply module of clause 7, wherein the exhaust unit is coupled to the exhaust outlet of the generator unit via a duct that extends from the first container and around the outside of the second container.
Clause 9. The power supply module of clauses 7 or 8, wherein the exhaust unit comprises a selective catalytic reduction (SCR) system.
Clause 10. The power supply module of any preceding clause, wherein the one or more electrical units comprise: a transformer, a ring main unit (RMU), one or more switchboards, one or more uninterruptible power supply (UPS) systems, one or more batteries, or any combination thereof.
Clause 11. The power supply module of any preceding clause, wherein the second container comprises one or more internal walls to partition the second volume into a plurality of compartments.
Clause 12. The power supply module of clause 11, wherein the one or more internal walls comprise an internal fire separation layer comprising a fire-retardant material.
Clause 13. The power supply module of clauses 11 orl2, wherein: the plurality of compartments includes a first compartment and a second compartment; the first compartment contains one or more batteries; and the second compartment contains an uninterruptible power supply (UPS) system and/or a switchboard.
Clause 14. The power supply module of clause 13, wherein: the plurality of compartments further includes a third compartment; and the third compartment contains a transformer.
Clause 15. The power supply module of any of clauses 11 to 14, wherein the second container comprises a plurality of container sections that couple together to form the second container.
Clause 16. The power supply module of clause 15, wherein the one or more internal walls are formed by the couplings between the plurality of container sections.
Clause 17. The power supply module of any of clauses 1 to 10, wherein the second container comprises a plurality of container sections that couple together to form the second container.
Clause 18. The power supply module of clause 17, further comprising an internal fire separation layer comprising a fire-retardant material, said internal fire separation layer disposed between the coupled container sections of the second container.
Clause 19. The power supply module of any preceding clause, wherein generator unit provides a power between 1.5MW and 10MW, preferably between 2MW and 5MW, more preferably wherein the generator unit is a 2.4MW generator.
Clause 20. The power supply module of any preceding clause, wherein the one or more electrical units are configured to output a first power supply stream for information technology (IT) equipment of the modular data centre.
Clause 21. The power supply module of clause 20, wherein the first power supply stream is output via one or more first switchboards, and preferably wherein the one or more first switchboards are coupled to one or more first UPS systems.
Clause 22. The power supply module of clauses 20 or 21, wherein the one or more electrical units are configured to output a second power supply stream for plant equipment of the modular data centre.
Clause 23. The power supply module of any of clause 22, wherein the second power supply stream is output via one or more second switchboards, and preferably wherein the one or more second switchboards are coupled to one or more second UPS systems.
Clause 24. The power supply module of any of clauses 20 to 23, wherein the first power supply stream is output via a plurality of output terminals.
Clause 25. The power supply module of clause 24, wherein each of the plurality of output terminals is associated with a respective portion of IT equipment of the modular data centre.
Clause 26. The power supply module of any of clauses 20 to 25, wherein the first power supply stream is equal to 1.5MW.
Clause 27. The power supply module of any preceding clause, wherein the one or more electrical units further comprise one of more load bank connection terminals.
Clause 28. The power supply module of any preceding clause, wherein: the first container comprises a first compartment, a second compartment and a third compartment; the first compartment comprises an air intake system configured to draw air into the first container for cooling the generator unit; the second compartment contains the generator unit; and the third compartment comprises an air discharge system configured to expel from the first container air heated by the generator unit.
Clause 29. The power supply module of clause 28, wherein: the air intake system comprises an inlet ventilation attenuator; and/or the air discharge system comprises a discharge ventilation attenuator.
Clause 30. The power supply module of clauses 28 or 29, wherein: the first compartment is located at a first end of the first container; the third compartment is located at a second end of the first container opposing the first end; and the second compartment is located between the first compartment and the third compartment.
Clause 31. The power supply module of clauses 28 to 30, wherein: the first compartment includes a first acoustic louvre passing through a sidewall of the first container, preferably passing through a first end wall of the first container; and the third compartment includes a second acoustic louvre passing through a sidewall of the first container, preferably passing through a second end wall of the first container.
Clause 32. The power supply module of any preceding clause, further comprising a fuel module configured to receive the first container with the base of the first container supported by the fuel module.
Clause 33. The power supply module of any of clauses 1 to 31, wherein the base of the first container comprises a fuel module integral with the first container.
Clause 34. The power supply module of clauses 32 or 33, further comprising a fuel tank positioned within the fuel module and configured to provide fuel to the generator unit.
Clause 35. The power supply module of any of clauses 1 to 33, further comprising a fuel tank located within the first volume and configured to provide fuel to the generator unit.
Clause 36. The power supply module of any preceding clause, wherein the first container comprises a plurality of container sections that couple together to form the first container.
Clause 37. The power supply module of any preceding clause, wherein the power supply module is a modular assembly, wherein the first container forms a first storey of the modular assembly, and the second container forms a second storey of the modular assembly.
Clause 38. The power supply module of any preceding clause, further comprising a ladder or staircase that extends along an outside wall of the first container for accessing the second container.
Clause 39. A modular data centre comprising:
   at least one data hall; and
   one or more power supply modules of any preceding clause configured to provide power to the data hall.
Clause 40. A method of constructing a power supply module for a modular data centre, the method comprising the steps of:
   providing a first container including a base and sidewalls, wherein the first container encloses a first volume containing a generator unit;
   providing a second container including a base and sidewalls, wherein the second container encloses a second volume containing one or more electrical units, said one or more electrical units configured to receive power from an external power supply or from the generator unit and configured to output power to a data hall of the modular data centre;
   stacking the second container above the first container with the base of the second container supported by the first container.
Clause 41. The method of clause 40, further comprising: coupling the second container to the first container during or after the stacking.
Clause 42. The method of clause 40 or 41, wherein providing the second container further comprises the steps of: providing a plurality of second container sections; and coupling the plurality of second container sections together to form the second container.
Clause 43. The method of any of clauses 40 to 42, wherein providing the first container further comprises the steps of: providing a plurality of first container sections; and coupling the plurality of first container sections together to form the first container.
Clause 44. A kit of parts for a power supply module of a modular data centre, the kit of parts comprising:
   a first container including a base and sidewalls, wherein the first container encloses a first volume;
   a generator unit;
   a second container including a base and sidewalls, wherein the second container encloses a second volume, and wherein the second container is configured to be stacked above the first container with the base of the second container supported by the first container; and
   one or more electrical units, said one or more electrical units configured to receive power from an external power supply or from the generator unit and configured to output power to a data hall of the modular data centre.
Clause 45. The kit of parts of clause 44, further comprising: an exhaust unit configured to be disposed on a roof of the second container and coupled to an exhaust outlet of the generator unit.

## Claims

1. A power supply module for a modular data centre, the power supply module comprising:
a first container including a base and sidewalls, wherein the first container encloses a first volume;
a generator unit located within the first volume;
a second container including a base and sidewalls, wherein the second container encloses a second volume, and wherein the second container is configured to be stacked above the first container with the base of the second container supported by the first container; and
one or more electrical units located within the second volume, said one or more electrical units configured to receive power from an external power supply or from the generator unit and configured to output power to a data hall of the modular data centre.

2. The power supply module of claim 1, wherein the one or more electrical units are configured to receive power from the generator unit during a failure of the external power supply.

3. The power supply module of any preceding claim, wherein the base of the first container and the base of the second container have the same footprint.

4. The power supply module of any preceding claim, further comprising a fire separation layer comprising a fire-retardant material, said fire separation layer disposed between the first container and the base of the second container when stacked.

5. The power supply module of claim 4, wherein the fire separation layer is removable in a direction perpendicular to the stacking direction of the first and second containers.

6. The power supply module of any preceding claim, further comprising an exhaust unit disposed on a roof of the second container, said exhaust unit coupled to an exhaust outlet of the generator unit.

7. The power supply module of claim 6, wherein:
the exhaust unit is coupled to the exhaust outlet of the generator unit via a duct that extends from the first container and around the outside of the second container; and/or
the exhaust unit comprises a selective catalytic reduction (SCR) system.

8. The power supply module of any preceding claim, wherein the one or more electrical units comprise: a transformer, a ring main unit (RMU), one or more switchboards, one or more uninterruptible power supply (UPS) systems, one or more batteries, or any combination thereof.

9. The power supply module of any preceding claim, wherein:
the second container comprises one or more internal walls to partition the second volume into a plurality of compartments,
preferably wherein the one or more internal walls comprise an internal fire separation layer comprising a fire-retardant material.

10. The power supply module of any proceeding claim, wherein:
the second container comprises a plurality of container sections that couple together to form the second container.

11. The power supply module of any preceding claim, wherein:
the one or more electrical units are configured to output a first power supply stream for information technology (IT) equipment of the modular data centre,
preferably wherein the one or more electrical units are configured to output a second power supply stream for plant equipment of the modular data centre.

12. The power supply module of any preceding claim, wherein:
the first container comprises a first compartment, a second compartment and a third compartment;
the first compartment comprises an air intake system configured to draw air into the first container for cooling the generator unit;
the second compartment contains the generator unit; and
the third compartment comprises an air discharge system configured to expel from the first container air heated by the generator unit.

13. The power supply module of any preceding claim, wherein the first container comprises a plurality of container sections that couple together to form the first container.

14. A modular data centre comprising:
at least one data hall; and
one or more power supply modules of any preceding claim configured to provide power to the data hall.

15. A method of constructing a power supply module for a modular data centre, the method comprising the steps of:
providing a first container including a base and sidewalls, wherein the first container encloses a first volume containing a generator unit;
providing a second container including a base and sidewalls, wherein the second container encloses a second volume containing one or more electrical units, said one or more electrical units configured to receive power from an external power supply or from the generator unit and configured to output power to a data hall of the modular data centre;
stacking the second container above the first container with the base of the second container supported by the first container.
